(19) Europäisches Patentamt

European Patent Office

Office européen des brevets

(11) **EP 1 684 428 A1**

(12) **EUROPEAN PATENT APPLICATION**

(43) Date of publication:
26.07.2006 Bulletin 2006/30

(51) Int Cl.:
*H03H 17/06* (2006.01)

(21) Application number: 05000549.5

(22) Date of filing: 13.01.2005

(84) Designated Contracting States:
**AT BE BG CH CY CZ DE DK EE ES FI FR GB GR HU IE IS IT LI LT LU MC NL PL PT RO SE SI SK TR**
Designated Extension States:
**AL BA HR LV MK YU**

(71) Applicant: **DEUTSCHE THOMSON-BRANDT GMBH**
**78048 Villingen-Schwenningen (DE)**

(72) Inventors:
• **Lo Muzio, Pierluigi**
**78048 Villingen-Schwenningen (DE)**
• **Schemmann, Heinrich**
**78048 Villingen-Schwenningen (DE)**

(74) Representative: **Rittner, Karsten et al**
**Deutsche Thomson-Brandt GmbH,**
**European Patent Operations,**
**Karl-Wiechert-Allee 74**
**30625 Hannover (DE)**

(54) **Sample rate converter**

(57)     The invention relates to an asynchronous sample rate converter (ASRC) for the conversion of the sample rate of digital data such as audio data or video data.

In the case of high over-sampling or sub-sampling factors an ASRC becomes quite complex. It is an object of the invention to provide an ASRC with a simplified design for such purposes.

It is suggested to use an ASRC which has a n-tap polyphase filter, whereby a computational entity performs a polynomial computation of the filter coefficients. The attenuation at the notch frequencies is best when using a Parzen window or a quadratic window.

Fig. 1

EP 1 684 428 A1

**Description**

This invention relates to electronic devices, in particular to circuitry and methods for the conversion of digitally sampled data. The invention can be used in all fields in which the sample rate of a stream of data has to be changed, and particularly in audio systems and video systems. Another application is the adaptation of the sampling rate of the base band signal to the high sampling rate of a digital modulator in a telecommunication system, e.g. ADSL.

Digitally sampling analog signals such as audio signals or video signals is generally known. When processing the sampled signals it is often desirable to mix sampled data having different sample rates. For that purpose a sample rate conversion is necessary in which the sampled signal is converted from a first sample rate to a second sample rate. As an example, audio signals are often sampled at rates of 11.025, 22.05 or 44.1 KHz, or at rates of 8, 16, 32, or 48 KHz. Converting a signal from 8 KHz to 11.025 KHz means applying a sampling factor of 441/320, which needs complex converters in order to avoid a degradation of the signal quality.

Sample rate converters can be categorized in synchronous sample rate converters and asynchronous sample rate converters. In the first case the sampling factor, which is the ratio of the output sampling rate and the input sampling rate, is a rational number such as 441/320. In the latter case the ratio cannot be expressed by a rational number.

US 5,907,295 discloses a synchronous sample rate converter (SSRC). The SSRC being used is a two-stage converter. A first stage is an L-tap low-pass FIR, and the second stage is a linear interpolator. The first stage adjusts the sampling rate by a factor of $Q_0/P_0$ and the second stage by a factor of $Q_1/P_1$, such that the overall sampling factor is $Q/P = Q_0/P_0 * Q_1/P_1$. Splitting the SSRC into two stages results in a decreased coefficient storage within the L-tap FIR. This SSRC is not suitable for sampling factors smaller than 1/8, or sampling factors larger than 8. Its performance in terms of signal to noise ratio (SNR) is also limited.

US 5,666,299 discloses an asynchronous sample rate converter (ASRC). The number of filter coefficients stored in a ROM are reduced by the design of the ASRC. This ASRC is not suitable for sampling factors smaller than 1/8, or sampling factors larger than 8. Its SNR is also limited.

US 5,638,010 discloses a digitally controlled oscillator (DCO) in a digital phase lock loop, for the synchronization of ASRCs with a high sampling factor. For this purpose, the DCO generates a suited clock signal. It also generates a residue signal, usable for the precise interpolation of data samples. This residue signal is related to the instantaneous phase of the DCO.

It is an object of the invention to provide a high-performance ASRC and a corresponding method for converting a sample rate from a first value to a second value.

The ASRC and the method should be usable for oversampled input signals and for very high or very low sampling factors of the converter.

According to the present invention the above-mentioned objects are achieved by providing the features defined in the independent claims. Preferred embodiments according to the invention additionally comprise the features defined in the sub-claims. It should be emphasized that any reference signs in the claims shall not be construed as limiting the scope of the invention.

According to the present invention the above-mentioned objects are achieved by an asynchronous sample rate converter which comprises an n-tap polyphase filter with n being an integer, and a computational entity for calculating the filter coefficients, whereby the computational entity is adapted to use a Parzen window or to use a quadratic window for calculating the filter coefficients.

The corresponding method is a method for converting the sample rate of digitally sampled data from a first sample rate to a second sample rate by using a conventional n-tap filter, whereby the filter coefficients are computed by using a Parzen window or by using a quadratic window.

These and other aspects of the invention will be apparent from and elucidated with reference to the embodiments described thereafter.

**Brief description of the drawings**

Fig. 1      shows the ASRC with a reduced computational complexity,

Fig. 2      shows the Parzen window, the quadratic window, and (for comparison reasons) the triangular window in the frequency domain,

Fig. 3      shows the first five notches of a Parzen window and a quadratic window,

Fig. 4      shows the first notch of a Parzen window and a quadratic window in more detail,

Fig. 5      a circuit exampling the generation of filter coefficients in the case of a quadratic window,

Fig. 6      a circuit exampling the generation of filter coefficients in the case of a Parzen window,

Fig. 7      a circuit comprising the ASRC of Fig. 1.

**Detailed description of the drawings and description of the preferred embodiments.**

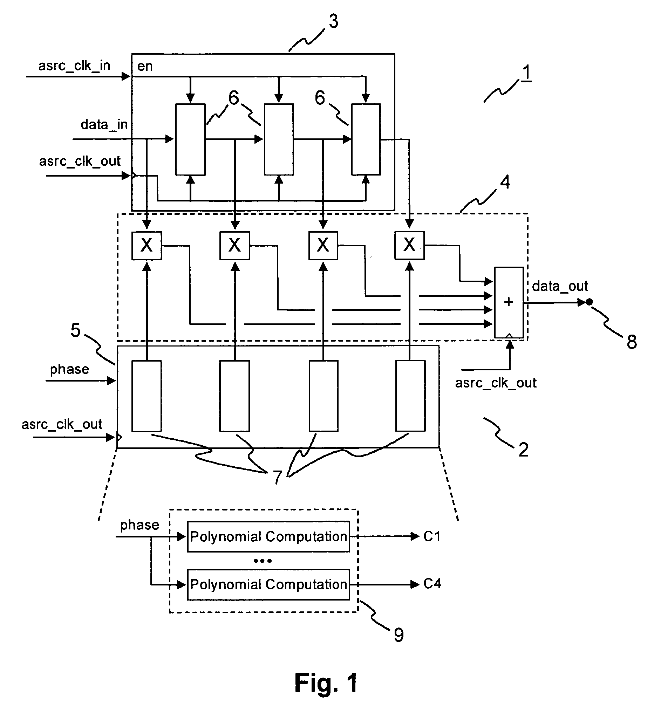

Fig. 1 schematically shows the ASRC 1 according to the invention. It comprises a 4-tap polyphase filter 2 which comprises a delay pipeline 3 and a digital signal processor (DSP) 4. The clock signal ascr_clk_in enables the delay pipeline 3 and clocks input data data_in sequentially through data registers (or flip-flops) 6, such that the utmost left register contains the newest sample, and the utmost right register the oldest sample.

The clock signal asrc_clk_in is in general a jittered clock because it is phase synchronous with asrc_clk_out and frequency synchronous with data_in. Typically this clock is generated by means of the DCO of a digital PLL. This DCO uses the same clock signal asrc_clk_out, which synchronizes all registers 6.

The ASRC 1 can be conveniently used when the input data data_in are represented by an oversampled signal. For the purposes of this disclosure an oversampled signal shall be understood to be a signal having a sample rate significantly higher than the minimum sampling rate $F_{MIN}$. Taking the Nyquist theorem into account the minimum sampling rate $F_{MIN}$ is twice the bandwidth.

Filtering is performed by averaging the sample points from the data registers 6. The sample points are multiplied by the DSP 4 with their corresponding weighing/filter coefficients. The sum of all weighted sample points is outputted by the DSP 4 at an output port 8.

In Fig. 1 the n-tap filter 2 (n is an integer) has four taps. The invention however is not restricted to a case of four taps. n may be chosen to be 2, 3, 4 ,...up to 10 or more.

There are two ways of generating the filter coefficients.

The first possibility is the generation of the filter coefficients by a computational entity, whereby the computational entity is at a location external to the converter. This computational entity might be hardware such as a DSP or an application-specific integrated circuit (ASIC), or may be a computer program running on a remote computer.

The second possibility is the generation of the filter coefficients by a computational entity, whereby the computational entity is at a location, said location being inside the converter. In other words the computational entity is part of the converter. In this case the computational entity is the coefficient generator 5 of Fig. 1. Advantageously, the coefficient generator 5 has a limited complexity when the input signals are oversampled signals.

When the first possibility is chosen the n-tap polyphase filter has to provide memory space for the filter coefficients which are generated externally (outside the n-tap polyphase filter). In this case the phase signal is used as the reading address of four independent memory units 7, whereby each memory unit 7 of block 5 holds all the $2^p$ possible values of a specific coefficient, with P = number of bits of the phase signal. For a precise interpolation, for instance with P=9, the required memory in block 5 is $2^9*4$ words. As can be derived from the above explanations, block 5 is a pure memory block in this (first) operation mode. Block 9 can be regarded as the external computational entity.

When the second possibility is chosen, the phase signal is used for the polynomial computation of the filter coefficients by means of a computational entity 5. Typically the phase signal is generated by the DCO of a digital PLL. The four coefficients are $C_1 = A_1 * I + B_1 * I^2 + C_1 * I^3 + D_1 * I^3$, whereby 1 is an index ranging from 1 to 4, and whereby I is the input phase signal. The coefficients are either calculated on the fly (online calculation), or have been preloaded (offline calculation).

When the second possibility for generating the filter coefficients is chosen the calculation of the filter coefficients is performed in block 5. In this (second) operation mode block 5 is a coefficient generator or computational entity. Details of block 5 serving as a computational entity is visualized by means of block 9. It should be emphasized however that block 9 is merely a representation of block 5, and is not a separate physical entity. Block 9 thus zooms into block 5. The constants $A_1$, $B_1$, $C_1$, $D_1$ etc. are retrieved from a small memory unit (not shown). In this example a third order polynomial is chosen, such that a total of 16 coefficients are stored, whereby each coefficient needs a memory space of only 4 words. This solution for the coefficient generator reduces the required memory at the expenses of additional polynomial computations and it is generally better when a very precise interpolation is needed.

The invention uses the Parzen window or the quadratic window as the polynomial smart window. The Parzen window, also referred to as the de la Valle Poussin window, is a third order polynomial and is defined as

$$w(n) = 1 - 6 \cdot \left(\frac{n}{N/2}\right)^2 \cdot \left(1 - \frac{|n|}{N/2}\right)$$

$0 \le |n| \le N/4$

$$w(n) = 2 \cdot \left(1 - \frac{|n|}{N/2}\right)^3$$

$N/4 \le |n| \le N/2$ whereby n is the index of the time samples, and N+1 is the total length of the window. In the alternative, a quadratic window is chosen. This is a second order polynomial which is defined as

$$w(n) = 1 - 2 \cdot \left(\frac{n}{N/2}\right)^2$$

$$0 \leq |n| \leq N/4$$

$$w(n) = 2 \cdot \left(1 - \frac{|n|}{N/2}\right)^2$$

$N/4 \leq |n| \leq N/2$

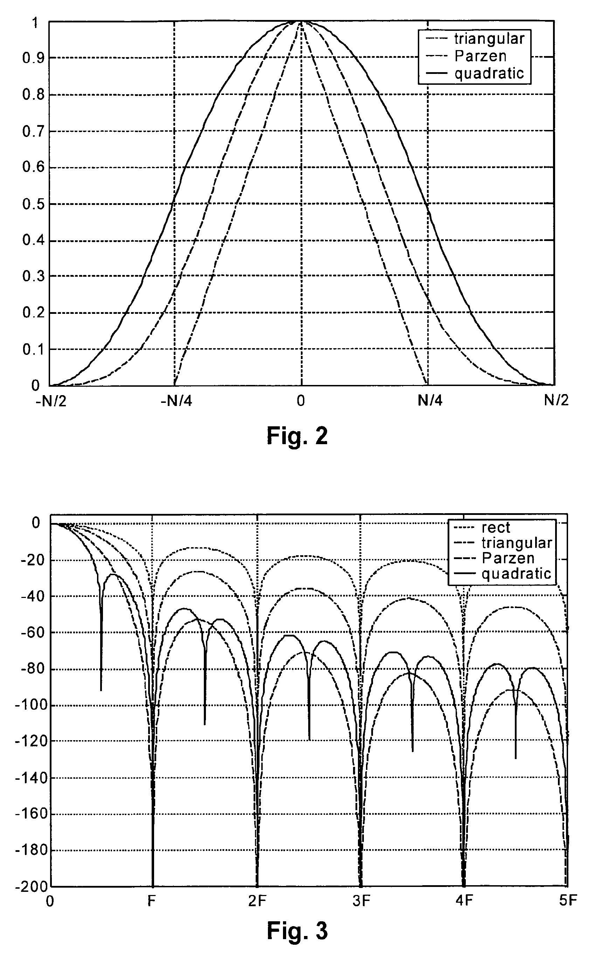

Both windows are shown in the time domain in Fig. 2, whereby the y-coordinate is normalized to 1. In addition, a triangular window is shown, which is basically known from the prior art. The curves stem from (from top to bottom) the quadratic window, the Parzen window, and the triangular window. The advantage of this second order or third order polynomial are repetitive notches of the prototype filter in the frequency domain with a particularly a high attenuation to avoid aliasing.

Both windows show a better performance (as far as the attenuation at the repetitive notches is concerned) when compared to a triangular window or to a rectangular window. As far as the above mentioned attenuation is concerned the Parzen window is even better than the quadratic window. The performance of the quadratic window is between the Parzen window and the triangular window.

The quadratic window is a smart window because it shows a double symmetry: an even symmetry around y=0, and an odd symmetry around (-N/4, 0.5) and (N/4, 0.5). The latter symmetry is useful when a multiple of four samples are used, because in this case half of the samples can be computed without other multiplications, applying a simple subtraction.

Fig. 3 shows the first five lobes of a Parzen window and a quadratic window in the frequency domain. For comparison purposes, the rectangular window and the triangular window are shown as well. When looking on the second lobe, the curves stem from (from top to bottom) the rectangular window, the triangular window, the quadratic window having two maxima, and the Parzen window. The y-axis denotes the attenuation in units of dB, and the x-axis is divided in units of F. F denotes the sampling frequency at the input of the ASRC. To make this comparison possible, the duration of the quadratic window and the Parzen window are doubled to get the first notch in the frequency domain at the proper frequency. The doubled duration implies a double number of taps: 4 taps for the Parzen window and the quadratic window, 2 taps in the case of the triangular window, and only 1 tap in the case of the rectangular window. The first notch is the most important notch as the attenuation is increased in the other notches. As can be seen, the attenuation for the Parzen window and the quadratic window is particularly high as desired.

Another advantage of the quadratic window is that it creates secondary notches at middle frequencies. This means that the over-sampling stage enjoys an additional stop-band attenuation.

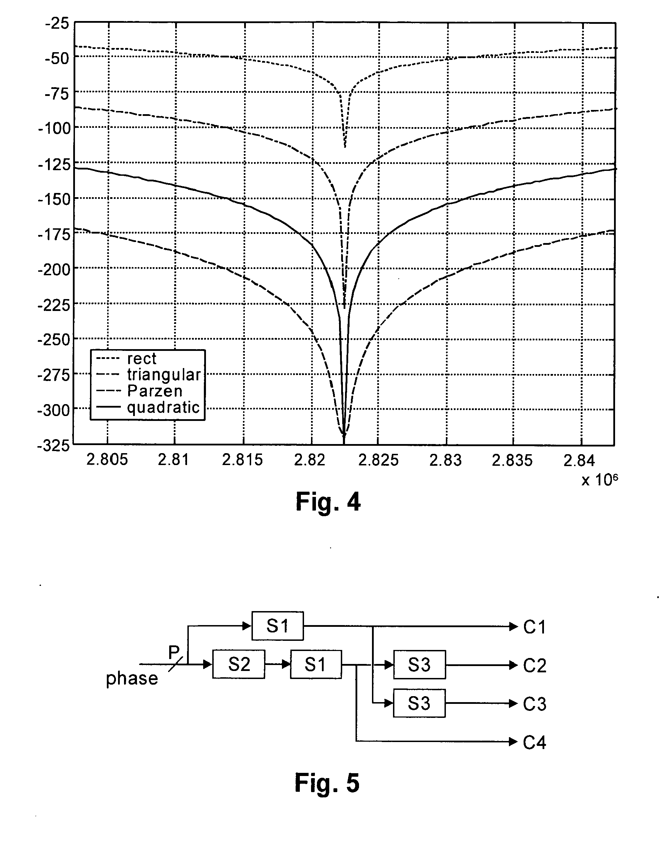

Still another advantage of the Parzen window and the quadratic window is that their dips in the frequency domain are particularly wide, such that bandwidth requirements at notch frequencies can be easily satisfied. This can be seen with the help of Fig. 4, in which the attenuation in dB is plotted versus the frequency in Hertz. The curves stem from (from top to bottom) the rectangular window, the triangular window, the quadratic window, and the Parzen window. The quadratic window attenuates at least - 125 dB in the whole bandwidth. This satisfies the specification of 16 bit audio with a large margin. 20 bit audio is satisfied with a small margin. The Parzen window is even better, such that it is particularly well suited for high-end applications of digital audio. For comparison, the first notch of the rectangular window and the triangular window, both used in the prior art, are shown as well. Their attenuation within the bandwidth of +/- 20 KHz is much poorer such that a compensation is needed.

The above formulae of the Parzen window and the quadratic window cannot be used directly to compute the filter coefficients by using the phase signals, whereby the phase signal might be provided by a DCO. In the case of the quadratic window, the coefficients C1, C2, C3 and C4 are computed as follows:

$$C_1 = k \cdot \varphi^2$$
$$C_2 = k \cdot \left(2 \cdot \left(\tfrac{N}{4}\right)^2 - \left(\tfrac{N}{4} - \varphi\right)^2\right)$$
$$C_3 = k \cdot \left(2 \cdot \left(\tfrac{N}{4}\right)^2 - \varphi^2\right)$$
$$C_4 = k \cdot \left(\tfrac{N}{4} - \varphi\right)^2$$

k is a constant which determines the filter gain, $\varphi$ is the phase signal from the DCO, $\frac{N}{4} = 2^P$, whereby P is the number of bits of the phase signal from the accumulator of the DCO.

In the case of the Parzen window, the coefficients are computed as follows:

$$C_1 = k \cdot \varphi^3$$
$$C_2 = k \cdot \left(4 \cdot \left(\tfrac{N}{4}\right)^3 - 3 \cdot \left(\tfrac{N}{4} + \varphi\right) \cdot \left(\tfrac{N}{4} - \varphi\right)^2\right)$$
$$C_3 = k \cdot \left(4 \cdot \left(\tfrac{N}{4}\right)^3 - 3 \cdot \left(\tfrac{N}{2} - \varphi\right) \cdot \varphi^2\right)$$
$$C_4 = k \cdot \left(\tfrac{N}{4} - \varphi\right)^3$$

Fig. 5 shows a circuit which exemplifies the generation of filter coefficients in the case of a quadratic window. If I is the input signal of each block, step S1 computes $I^2$, and outputs this value as the filter coefficient C1. Step S2 computes $2^P - I$ and step S3 computes $2^{2 \cdot P - 1} - I$. The constant k has been omitted because its value depends on the specific gain to be obtained in the filter. No memory is needed as all coefficients are calculated on the fly by simple operations. Neglecting trivial shifts and simple additions or subtractions, only two multipliers or square operations are needed.

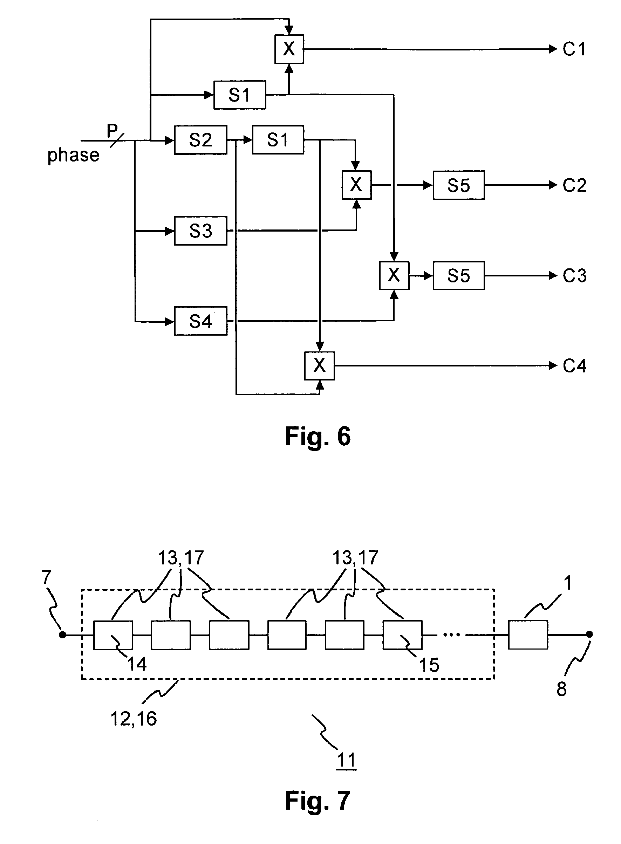

Fig. 6 shows a circuit which exemplifies the generation of filter coefficients in the case of a Parzen window. In addition to steps S1 and S2 there are additional computation steps S3, which computes $2^P+1$, S4, which computes $2^{P+1}+1$, and S5, which computes $2^{3P+2}-3*I$.

Fig. 7 schematically shows the use of the ASRC 1 of the present invention and its particular advantages to convert the sample rate of digitally sampled data to a much higher or much lower sampling rate.

Circuit 11 has an input port 7 for input signals having a first sample rate, and an output port 8 for signals having a second sample rate. In this case the input data at port 7 are not oversampled like data_in of Fig.1. Instead, the whole converter 11 provides a sampling factor which is higher than 8 or lower than 1/8.

Circuit 11 consists of an interpolation stage 12 with an integer sampling factor and an ASRC 1 as explained above. The interpolation stage 12 may be chosen to be composed of interpolation units 13, whereby each interpolation unit interpolates by a factor of 2. Splitting the interpolation stage 12 into a couple of interpolation units, whereby each interpolation unit interpolates by a factor of 2, has the advantage that the overall design of the circuit 11 becomes simpler. All interpolation units 13 are connected in series. The first interpolation unit 14 is connected to the input port 7, and the last interpolation unit 15 is connected to the ASRC

1. As can be derived from this explanation, the circuit 11 represents an ASRC, being composed of an interpolation stage 12 and a residual ASRC 1.

In the second case the interpolation stage 12 is replaced by a decimation stage 16 with an integer decimation factor (=1/sampling_factor) of at least 4. The decimation stage 16 may be chosen to be composed of decimation units 17, whereby each decimation unit decimates by a factor of 2. All decimation units 13 are connected in series. Furthermore, the residual ASRC 1 is the first stage into which the input signal is fed, and the decimation stage is the second stage outputting the output signal with the second sample rate. In other words port 8 becomes the input port, and port 7 the output port. For reasons of convenience, the following description will not discuss this second case in detail, as the advantages are identical.

The idea of the circuit 11 is to split the ASRC into an interpolation stage 12 with an integer interpolation factor of at least 4 and a residual ASRC. Further advantage is obtained by the split of the stage 12 into multiple interpolation units 13, each one interpolating the sample rate by a factor of 2. The particular advantage of the circuit 11 is that the residual ASRC 1 has to handle a sampling factor which is smaller than without the preceding interpolation stage 12. Therefore the computational burden for the ASRC 1 is decreased. This allows a simpler design for the ASRC 1.

As mentioned above, the ASRC 1 of the present invention is particularly well suited for input signals having a high sampling rate $F/F_{MIN}$ (or low sampling rate in the dual case). A signal with a high sampling rate is provided by the interpolation stage 12 of the circuit 11. The absolute value of $F/F_{MIN}$ which can be chosen mainly depends on two aspects.

One aspect is the design of the circuit 11. On the one hand the design of the ASRC 1 is simplified, and on the other hand the complexity of the circuit 11 is increased by the additional interpolation stage 12. From a practical point of view splitting the total ASRC into an interpolation stage 12 and a residual ASRC 1 may be acceptable if the sampling factor of the interpolation stage 12 is at least 8, such that a separated interpolation by 4 is needed .

A second aspect is the SNR of the ASRC 1 which is acceptable to the user. $F_{IN}$ may denote the input sampling rate of the ASRC 1, $F_{OUT}$ the corresponding output sampling rate, and B may denote the signal bandwidth. The question then is: what is the sampling rate F which must by provided for by the interpolation stage 12 in order to have a desired SNR of the output signal of the ASRC 1, and which window (quadratic or Parzen) should be chosen? Two cases can be distinguished:

a) if $F_{OUT} > F_{IN} > F_{OUT/2}$ then F is chosen to be $F_{IN}$. In this case no interpolation stage 12 is needed at all. The Parzen window offers a better chance to yield the desired SNR to obtain an attenuation of -SNR dB in the frequency range [F-B, F+B] around F in the first notch of Fig. 3 when compared to the quadratic window.

b) if $F_{IN} < F_{OUT}/2$ then a trade-off between the complexity of the interpolation stage 12, the complexity of the window, and the required SNR must be found. Generally speaking a higher order window and a higher number of interpolation units improve the SNR. For instance, the maximum number of interpolation units can be chosen till the limit of $F < F_{OUT}$. Then the proper window is selected to satisfy the SNR specification.

**List of reference numerals**

01 ASRC
02 n-tap polyphase filter
03 delay pipeline
04 digital signal processor
05 block
06 data register
07 memory unit
08 output port

09 computational entity
10 input port
11 circuit
12 interpolation stage
13 interpolation unit
14 first interpolation unit
15 last interpolation unit
16 decimation stage
17 decimation unit

**Claims**

1.  Asynchronous sample rate converter (1) including:

    - an n-tap polyphase filter (2) with n being an integer, and
    - a computational entity (5,9) for calculating the filter coefficients,
    - **whereby** the computational entity is adapted to use a Parzen window or to use a quadratic window for calculating the filter coefficients.

2.  Converter according to claim 1, **whereby** n has a value between 2 and 10.

3.  Converter according to claim 1, **whereby** the computational entity is at a location external to the converter.

4.  Converter according to claim 3, **whereby** the computational entity is a computer program.

5.  Converter according to claim 1, **whereby** the computational entity is at a location inside the converter.

6.  Converter according to claim 1, **further** including a stage (12,16) for interpolating or for decimating the sample rate by an integer factor.

7.  Converter according to claim 6, **whereby** the interpolation stage is composed of interpolation units (13), and whereby each interpolation unit interpolates by a factor of 2.

8.  Converter according to claim 6, **whereby** the decimation stage is composed of decimation units (17), and whereby each decimation unit decimates by a factor of 2.

9.  Converter according to claim 1, **whereby** the unit (13,17) for interpolating or decimating the sample rate is a microprocessor or a digital signal processor.

10. Converter according to claim 1, **whereby** the unit (13,17) for interpolating or decimating the sample rate is a linear interpolator or a linear decimator.

11. Method for converting the sample rate of digitally sampled data from a first sample rate to a second sample rate by using a conventional n-tap filter (2), **whereby** the filter coefficients are computed by using a Parzen window or by using a quadratic window.

12. Method according to claim 11, **whereby** the filter coefficients are calculated at a location external to the n-tap polyphase filter.

13. Method according to claim 12, **whereby** the filter coefficients are calculated means of by a computer program running on a computational entity (9).

14. Method according to claim 11, **whereby** the filter coefficients are calculated at a location inside the n-tap polyphase filter.

**Fig. 1**

**Fig. 2**

**Fig. 3**

**Fig. 4**

**Fig. 5**

**Fig. 6**

**Fig. 7**

**European Patent Office**

**EUROPEAN SEARCH REPORT**

Application Number

EP 05 00 0549

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,A | US 5 666 299 A (ADAMS ET AL) 9 September 1997 (1997-09-09) * column 1, line 20 - column 4, line 67 * ----- | 1-14 | H03H17/06 |
| A | ADAMS R ET AL: "A STEREO ASYNCHRONOUS DIGITAL SAMPLE-RATE CONVERTER FOR DIGITAL AUDIO" IEICE TRANSACTIONS ON ELECTRONICS, INSTITUTE OF ELECTRONICS INFORMATION AND COMM. ENG. TOKYO, JP, vol. E77-C, no. 5, 1 May 1994 (1994-05-01), pages 811-818, XP000459521 ISSN: 0916-8524 * the whole document * ----- | 1-14 | |

| | | | TECHNICAL FIELDS SEARCHED (Int.Cl.7) |
|---|---|---|---|
| | | | H03H |

The present search report has been drawn up for all claims

| Place of search | Date of completion of the search | Examiner |
|---|---|---|
| The Hague | 18 April 2005 | Lecoutre, R |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 .........................................................................

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 05 00 0549

This annex lists the patent family members relating to the patent documents cited in the above-mentioned European search report.
The members are as contained in the European Patent Office EDP file on
The European Patent Office is in no way liable for these particulars which are merely given for the purpose of information.

18-04-2005

| Patent document cited in search report | | Publication date | Patent family member(s) | | Publication date |
|---|---|---|---|---|---|
| US 5666299 | A | 09-09-1997 | US | 5471411 A | 28-11-1995 |
| | | | US | 5475628 A | 12-12-1995 |
| | | | AT | 164273 T | 15-04-1998 |
| | | | DE | 69317573 D1 | 23-04-1998 |
| | | | EP | 0663118 A1 | 19-07-1995 |
| | | | EP | 0774835 A2 | 21-05-1997 |
| | | | JP | 8502395 T | 12-03-1996 |
| | | | WO | 9408395 A1 | 14-04-1994 |
| | | | US | 6141671 A | 31-10-2000 |

EPO FORM P0459

For more details about this annex : see Official Journal of the European Patent Office, No. 12/82